# EUROPEAN PATENT APPLICATION

(11) **EP 3 007 529 A1**
(43) Date of publication of application: **13.04.2016**
(21) Application number: 13886608.2
(22) Date of filing: 04.06.2013
(51) Int. Cl.: H05K 7/14

(54) **MOTOR CONTROL DEVICE**

(71) Applicant: Kabushiki Kaisha Yaskawa Denki, Kitakyushu-shi, Fukuoka 806-0004 (JP)
(72) Inventor: KUSUMI Michinori, Kitakyushu-shi Fukuoka 806-0004 (JP)
(74) Representative: Grünecker Patent- und Rechtsanwälte PartG mbB
(86) International application number: PCT/JP2013/065441
(87) International publication number: WO 2014/196016

(57) **Abstract**

[Problem to be Solved]

A board can firmly be fixed to a housing and is conveniently removed from the housing.

[Solution]

A motor control device 100 configured to control a motor, the motor control device 100 includes a box-shaped housing 1 including an opening part 1a, a printed circuit board 3 inserted into the housing 1 and extracted from the housing 1 through the opening part 1a and including an engaged part 11 on a side surface on one side in insertion-extraction direction, and an engaging member 21 disposed on a back wall part 1d of the housing 1 on the one side in the insertion-extraction direction, engaging with the engaged part 11 of the inserted printed circuit board 3 to regulate movement of the printed circuit board 3 in the insertion-extraction direction, and being operated toward the other side in the insertion-extraction direction from the outside of the housing 1 to release the engagement.

## Description

### TECHNICAL FIELD

A disclosed embodiment relates to a motor control device.

### BACKGROUND ART

An information processing device has hitherto been known in which a printed circuit board with a plurality of electronic components mounted thereon is disposed in a housing (see, e.g., Patent Document 1). This information processing device has respective cutouts formed in an upper side surface and a lower side surface of the printed circuit board and these portions are engaged with locking portions formed in end portions of guide grooves to fix the printed circuit board to the housing.

### PRIOR ART DOCUMENT

### PATENT DOCUMENT

Patent Document 1: JP, A, 2001-111264

### DISCLOSURE OF THE INVENTION

### PROBLEM TO BE SOLVED BY THE INVENTION

In the information processing device of the prior art, a printed circuit board removing jig is inserted into the housing to release the engagement between the cutouts of the printed circuit board and the locking portions. In this case, an operator must insert both end portions of the jig equally into the housing so that the engagement is released at the same time on the both upper and lower sides. Since the jig is necessary for removing the printed circuit board from the housing as described above and an operation using the jig is cumbersome, the prior art is inconvenient for an operator.

The present invention was conceived in view of the problem and it is therefore an object of the present invention to provide a motor control device in which a board can firmly be fixed to a housing and can conveniently be removed from the housing.

### MEANS FOR SOLVING THE PROBLEM

In order to solve the above-mentioned problem, according to an aspect of the present invention, there is provided a motor control device configured to control a motor, the motor control device including a box-shaped housing including an opening part, a printed circuit board inserted into the housing and extracted from the housing through the opening part and including an engaged part on a side surface on one side in an insertion-extraction direction, and an engaging member disposed on a wall part of the housing on the one side in the insertion-extraction direction, engaging with the engaged part of the printed circuit board inserted into the housing to regulate movement of the printed circuit board in the insertion-extraction direction, and being operated toward the one side or another side in the insertion-extraction direction from an outside of the housing to release the engagement.

In order to solve the above-mentioned problem, according to an aspect of the present invention, there is provided a motor control device configured to control a motor, the motor control device including a box-shaped housing including an opening part, a printed circuit board inserted into the housing and extracted from the housing through the opening part, including a connector, mounted on the printed circuit board, into which a connection target object is inserted and from which the connection target object is extracted in an insertion-extraction direction, and including an engaged part on a side surface on one side in the insertion-extraction direction at a position corresponding to the connector in a direction perpendicular to the insertion-extraction direction, and an engaging member disposed on a wall part of the housing on the one side in the insertion-extraction direction, engaging with the engaged part of the printed circuit board inserted into the housing to regulate movement of the printed circuit board in the insertion-extraction direction, and being operated toward the one side or another side in the insertion-extraction direction from an outside of the housing to release the engagement.

In order to solve the above-mentioned problem, according to an aspect of the present invention, there is provided a motor control device configured to control a motor, the motor control device including a box-shaped housing including an opening part, a printed circuit board inserted into the housing and extracted from the housing through the opening part, and means, disposed on the housing, for engaging with a side surface of the printed circuit board inserted into the housing on one side in an insertion-extraction direction to regulate movement of the printed circuit board in the insertion-extraction direction, and for releasing the engagement by operated toward the one side or another side in the insertion-extraction direction from an outside of the housing.

In order to solve the above-mentioned problem, according to an aspect of the present invention, there is provided an electronic equipment including a box-shaped housing including an opening part, a printed circuit board inserted into the housing and extracted from the housing through the opening part and including an engaged part on a side surface on one side in an insertion-extraction direction, and an engaging member disposed on a wall part of the housing on the one side in the insertion-extraction direction, engaging with the engaged part of the printed circuit board inserted into the housing to regulate movement of the printed circuit board in the insertion-extraction direction, and being operated toward the one side or another side in the insertion-extraction direction from an outside of the housing to release the engagement.

### ADVANTAGES OF THE INVENTION

According to the motor control device of the present invention, the board can firmly be fixed to the housing and can conveniently be removed from the housing.

### BRIEF DESCRIPTION OF THE DRAWINGS

Fig. 1A is a view perspectively showing a whole completed body of a motor control device of an embodiment.
Fig. 1B is a view perspectively showing a half-disassembled state of the motor control device of the embodiment.
Fig. 2 is a view perspectively showing a finely disassembled state of the motor control device.
Fig. 3A is a view showing a configuration of an engagement mechanism.
Fig. 3B is a view showing a configuration of the engagement mechanism.
Fig. 3C is a view showing a configuration of the engagement mechanism.
Fig. 3D is a view showing a configuration of the engagement mechanism.
Fig. 4A is an enlarged view showing an engaged part.
Fig. 4B is an enlarged view showing an engaging member.
Fig. 5 is a view showing a half-inserted state of the engagement mechanism at the time of housing of a printed circuit board.
Fig. 6 is a view showing a state in which the printed circuit board is housed with the engagement mechanism engaged.
Fig. 7 is a view showing a state in which the engagement of the engagement mechanism is released.
Fig. 8 is a view in the case that the engaged part of the printed circuit board includes a convex part.
Fig. 9A is a view in the case that the engaging member of a housing has a simplified configuration.
Fig. 9B is a view in the case that the engaging member of the housing has a simplified configuration.
Fig. 9C is a view in the case that the engaging member of the housing has a simplified configuration.
Fig. 10A is a view showing a configuration of the engagement mechanism in the case that the protruding part is pulled down to release the engagement.
Fig. 10B is a view showing a configuration of the engagement mechanism in the case that the protruding part is pulled down to release the engagement.

### BEST MODE FOR CARRYING OUT THE INVENTION

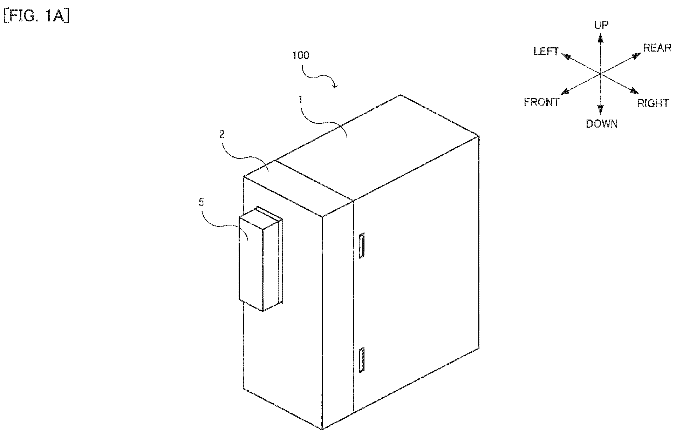

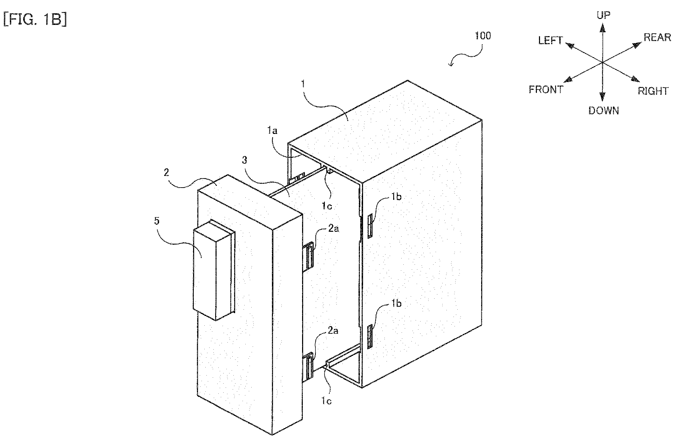

An embodiment will now be described with reference to the drawings. Front, rear, left, right, top, and bottom in the following description indicate directions noted by "front," "rear," "left," "right," "top," and "bottom" shown in Fig. 1. The correspondence of these directions is uniformly used only in the description of this embodiment and may appropriately be changed in accordance with a posture when the motor control device is disposed in another posture.

Fig. 1A perspectively shows a whole completed body of a motor control device of this embodiment and Fig. 1B perspectively shows a half-disassembled state of the motor control device. A motor control device 100 is, for example, control equipment such as a controller unit, a PLC (programmable logic controller) unit, an inverter unit, a servo unit, a power source unit, an I/O unit, a sensor unit, a switch unit, a safe unit, and a relay unit for controlling a motor. The motor control device 100 is not limited to such control equipment and may be any electronic equipment having a printed circuit board inserted into and extracted from a box-shaped housing. As shown in Fig. 1A, the whole completed body of the motor control device 100 has a substantially rectangular parallelepiped shape. The entire outer contour of the motor control device 100 can be disassembled into a lid part 2 that is a front portion and a housing 1 that is a rear portion as shown in Fig. 1B, and a printed circuit board 3 is housed inside the housing 1.

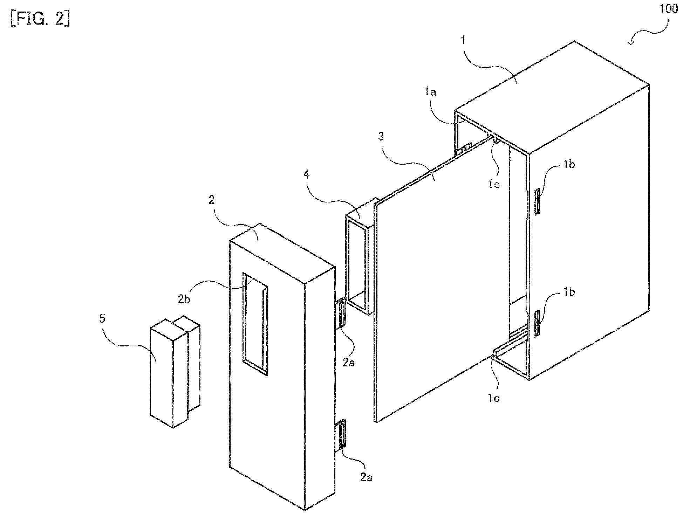

Fig. 2 is a view perspectively showing the motor control device 100 disassembled more finely than Fig. 1B from the same direction as Figs. 1A and 1B. In Fig. 2, the motor control device 100 has the housing 1, the lid part 2, and the printed circuit board 3 as described above. The housing 1 is a box body opened on the front side and can house the printed circuit board 3 therein. The lid part 2 is a member capable of entirely covering a front opening part 1a of the housing 1 and includes four locking claws 2a on the rear. The number of the locking claws 2a is not limited to four and may be any other number. Each of these locking claws 2a has a projection toward left or right and, when the lid part 2 covers the opening part 1a of the housing 1, the locking claws 2a are each inserted inside the housing 1 and locked in respective corresponding locking holes 1b. The coupling between the lid part 2 and the housing 1 is maintained by the locking between the locking claws 2a and the locking holes 1b. The directions of the projections of the locking claws 2a are not limited to right or left and may be any other directions.

Guide rails 1c are respectively disposed on a top plate on the top and a bottom plate on the bottom inside the housing 1 at the same positions in the left-right direction. Each of the guide rails 1c has a groove with substantially the same width as the thickness of the printed circuit board 3 and extends along front-rear direction. The printed circuit board 3 is inserted with upper and lower sides thereof fitted in the respective grooves of the guide rails 1c from the front opening part 1a toward the rear inner side of the housing 1. A front portion of the printed circuit board 3 includes a female connector 4 (connector) that can mechanically and electrically be attached/detached (connected, separated) to/from a male connector (connection target object) of a cable not shown for connecting another equipment. A connection hole 2b is opened in the front surface of the lid part 2 in conformity with the disposition of a junction part of the female connector 4. In Fig. 2, a dummy male connector 5 is joined instead of a male connector of a cable. The relation of male and female of the male connector 5 and the female connector 4 may be inverted.

As shown in Fig. 1A, the completed body of the motor control device 100 allows the female connector 4 of the printed circuit board 3 to couple through the connection hole 2b of the lid part 2 to the male connector 5 on the outside. The insertion-extraction direction of the female connector 4 and the male connector 5 is in parallel relation with the insertion-extraction direction of the printed circuit board 3 relative to the housing 1. The insertion-extraction direction in this case includes both the insertion direction (to the rear) and the extraction direction (to the front) of the printed circuit board 3 relative to the housing 1 and corresponds to the front-rear direction. In the motor control device 100, only the housing 1 is set on and fixed to a base not particularly shown. In the case that the female connector 4 and the male connector 5 are firmly coupled, when the male connector 5 is pulled forward in an attempt to remove the male connector 5 from the motor control device 100, the coupling between the lid part 2 and the housing 1 cannot be maintained by only the locking between the locking claws 2a of the lid part 2 and the locking holes 1b of the housing 1, and the lid part 2 and the printed circuit board 3 may be extracted together from the housing 1 as shown in Fig. 1B. In this regard, the motor control device 100 of this embodiment has an engagement mechanism disposed inside the housing 1 for firmly coupling the housing 1 and the printed circuit board 3.

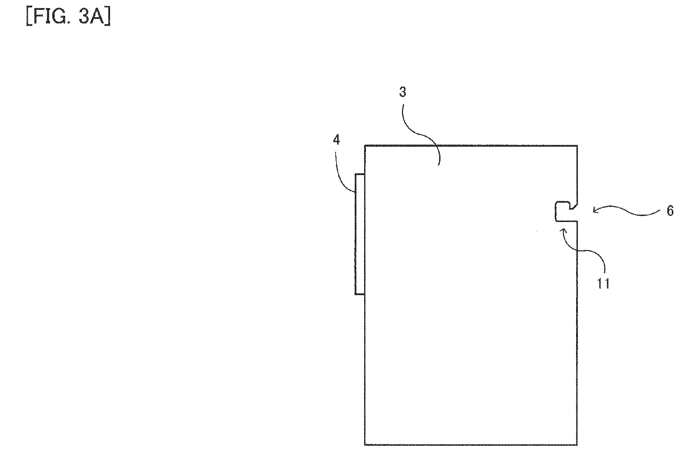

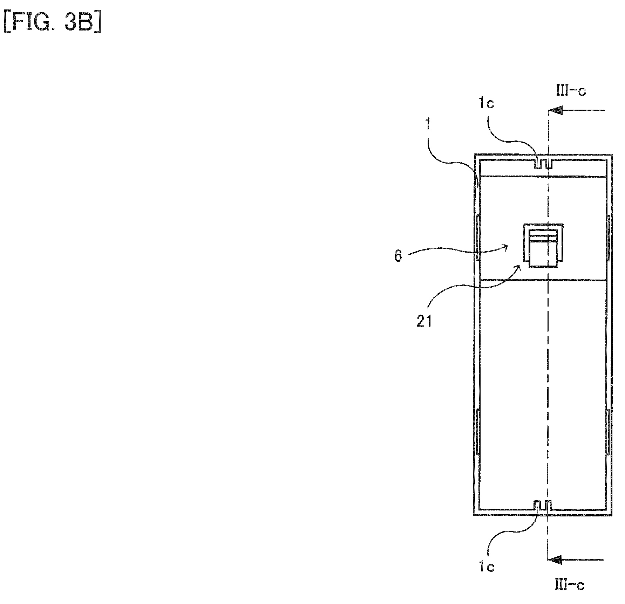

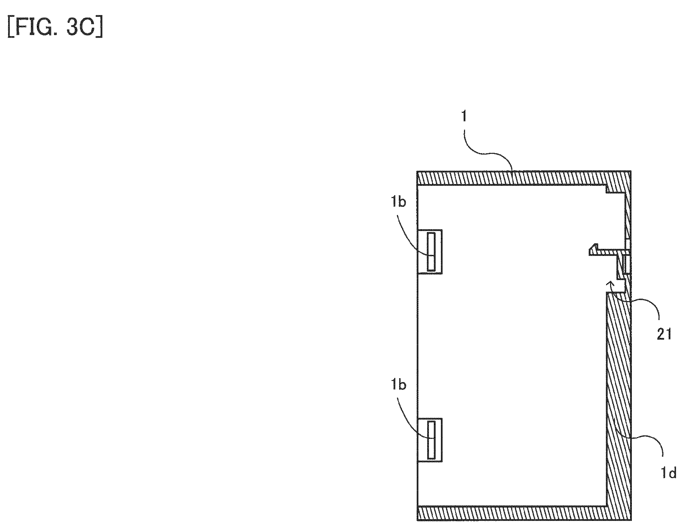

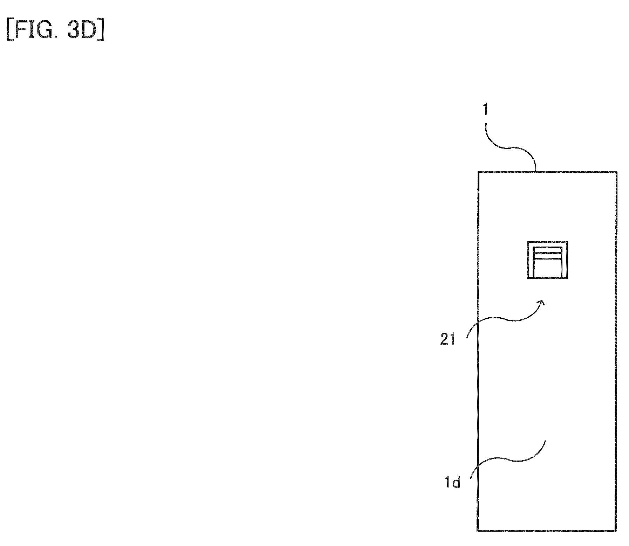

Figs. 3A to 3D show a configuration of the engagement mechanism; Fig. 3A is a side view of the printed circuit board 3 viewed from the right; Fig. 3B is a front view of the housing 1 viewed from the front; Fig. 3C is a side cross-sectional view of a cross section indicated by arrows III-c of Fig. 3B; and Fig. 3D is a back view of the housing 1 viewed from the rear. In Fig. 3A, the printed circuit board 3 has an engaged part 11 disposed on an edge portion on the rear thereof (a side surface on one side in the insertion-extraction direction). In Figs. 3B, 3C, and 3D, an engaging member 21 is disposed on a back wall part 1d of the housing 1 (a wall part of the housing on one side in the insertion-extraction direction) at substantially the same horizontal position as the guide rail 1c and at a height position corresponding to the engaged part 11. The engagement mechanism 6 includes the engaged part 11 of the printed circuit board 3 and the engaging member 21 of the housing 1.

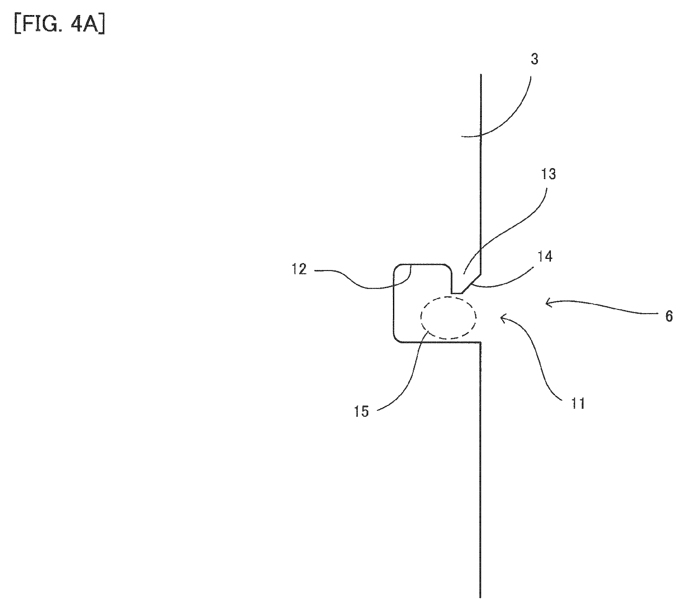

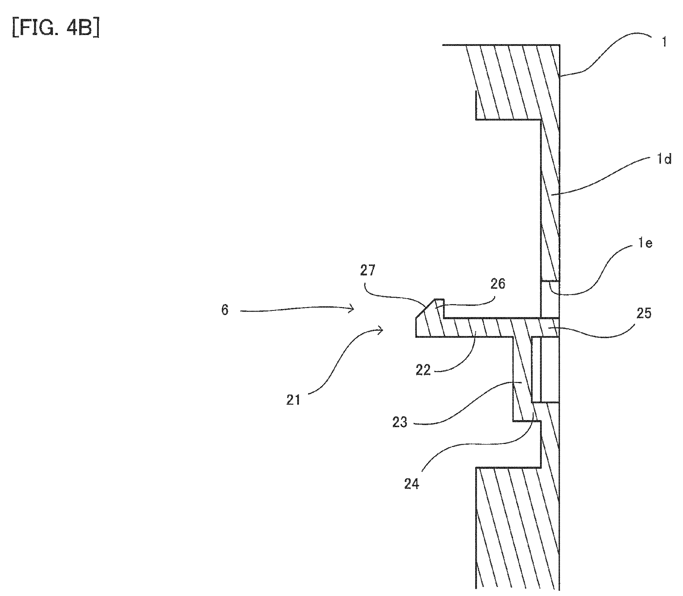

Fig. 4A is an enlarged view of the engaged part 11 and Fig. 4B is an enlarged view of the engaging member 21. In Fig. 4A, the engaged part 11 of the printed circuit board 3 has a concave part 12 and an engaged projection part 13. The concave part 12 is formed into a substantially rectangular shape like a cutout from the edge portion on the rear toward the front of the printed circuit board 3. The engaged projection part 13 (first projection part) is a projection part protruding from an upper side of an opening position of the concave part 12 toward the bottom and has an inclined surface 14 (a surface extending between the lower left and the upper right in Fig. 4A) on the rear bottom side thereof.

In Fig. 4B, the engaging member 21 integrally has a first extending part 22, a second extending part 23, a third extending part 24, a protruding part 25, and an engaging projection part 26 on the back wall part 1d of the housing 1. The first extending part 22 extends along front-rear direction and includes the engaging projection part 26 at the end portion on the front side. The second extending part 23 extends along top-bottom direction and has an end portion on the top side coupled to the first extending part 22 and an end portion on the bottom side coupled through the third extending part 24 described later to the back wall part 1d of the housing 1, and the second extending part 23 itself has flexibility. The third extending part 24 extends along front-rear direction and has an end portion on the front side coupled to the end portion on the bottom side of the second extending part 23 and an end portion on the rear side coupled to the back wall part 1d of the housing 1. Because of being coupled through the third extending part 24 to the back wall part 1d, the second extending part 23 is located on the inner side (e.g., on the front side) relative to the back wall part 1d and has the end portion on the top side coupled to an end portion on the rear side of the first extending part 22 (in other words, at an intermediate position between the first extending part 22 and the protruding part 25 described later). At the end portion on the rear side, the first extending part 22 has the protruding part 25 protruding toward the rear side relative to the position of coupling to the second extending part 23 and having a tip end approximately flush with an outer peripheral surface of the back wall part 1d. The engaging projection part 26 (second projection part) is a projection part protruding upward from the end portion on the front side of the first extending part 22 and has an inclined surface 27 (a surface extending between the lower left and the upper right in Fig. 4B) on the front top side thereof.

The back wall part 1d of the housing 1 has an operation hole 1e allowing an operator to easily touch the protruding part 25 with a finger thereof etc. The engaged part 11 of the printed circuit board 3 and the engaging member 21 of the housing 1 are arranged such that the respective inclined surfaces 14, 27 are in arrangement relation of substantially the same positions in top-bottom direction (a direction perpendicular to the insertion-extraction direction).

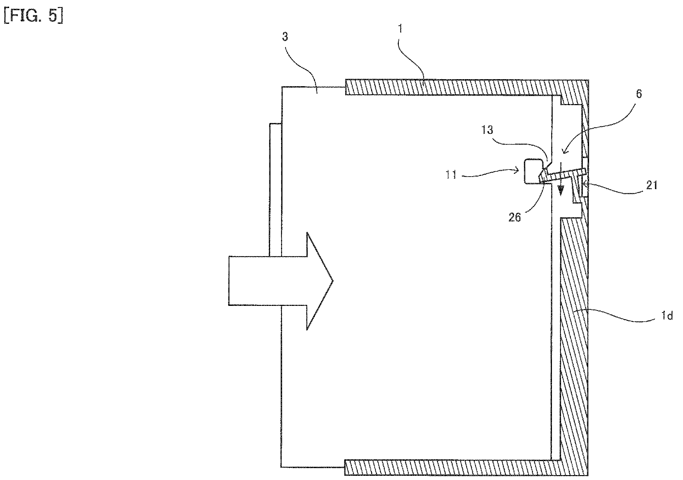

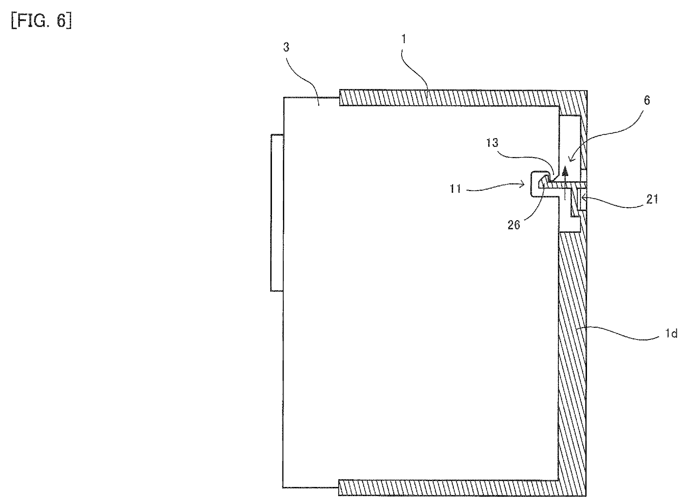

An operation of the engagement mechanism 6 at the time of housing of the printed circuit board 3 into the housing 1 and the time of disassembling will hereinafter be described. Fig. 5 is a view showing a half-inserted state of the engagement mechanism 6 at the time of housing of the printed circuit board 3 and corresponds to the side view of the printed circuit board 3 of Fig. 3A and the side cross-sectional view of Fig. 3C. By inserting the printed circuit board 3 along the guide rails 1c in the housing 1 to the inside, the engaged projection part 13 of the printed circuit board 3 and the engaging projection part 26 of the housing 1 are brought into contact with each other on the respective inclined surfaces 14, 27. By continuing the insertion of the printed circuit board 3 from this state, the inclined surfaces 14, 27 slip on each other and a component force pushing down toward the bottom acts on the engaging projection part 26. As a result, the second extending part 23 of the engaging member 21 is bent and the engaging projection part 26 swings toward the bottom. Therefore, the printed circuit board 3 can further be inserted inside the housing 1 and, when the engaging projection part 26 finally returns to the original height position as shown in Fig. 6, the engaged projection part 13 is engaged with the engaging projection part 26.

In this case, the rear edge portion of the printed circuit board 3 other than the periphery of the engagement mechanism 6 abuts on the inner surface of the back wall part 1d of the housing 1 and the printed circuit board 3 can no longer be inserted. Therefore, in this state, the movement of the printed circuit board 3 is regulated in both directions toward the front and the rear by the engagement in the engagement mechanism 6 and the abutment onto the back wall part 1d and, thus, the printed circuit board 3 and the housing 1 are firmly coupled inside the housing 1. As a result, even in the case that male connector 5 coupled to the female connector 4 of the printed circuit board 3 is pulled away, the lid part 2 and the printed circuit board 3 can be prevented from being extracted together from the housing 1 as shown in Fig. 1B, and the coupling state of the housing 1 and the printed circuit board 3 can be maintained. The engagement mechanism 6 may be disposed on a close position corresponding to the female connector 4 of the printed circuit board 3 in the top-bottom direction so as to prevent a component force in the top-bottom direction or a rotation direction from acting on the engagement mechanism 6 due to an offset between the disposition position of the female connector 4 and the disposition position of the engagement mechanism 6 in the top-bottom direction.

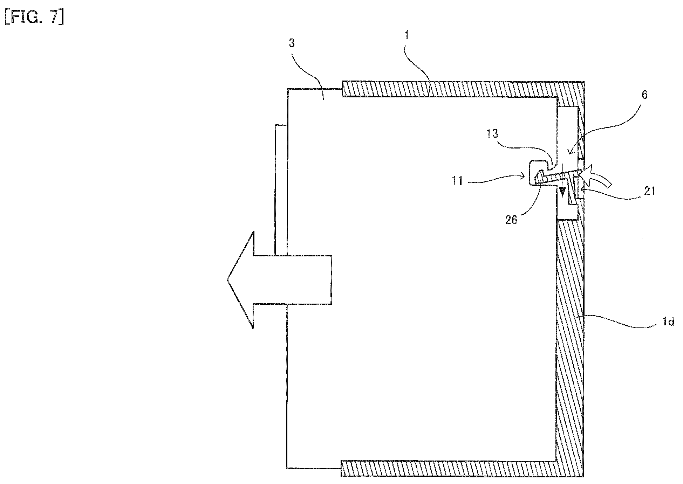

In the case that the printed circuit board 3 is desirably removed from inside the housing 1 on purpose for maintenance etc., the protruding part 25 of the engaging member 21 is operated as shown in Fig. 7 through the operation hole 1e with a finger of an operator (not shown) such that the protruding part 25 is slightly lifted and pushed toward the inside (e.g., the front side) of the housing 1. As a result, the second extending part 23 of the engaging member 21 is bent and the engaging projection part 26 moves toward the bottom. By releasing the engagement between the engaging projection part 26 and the engaged projection part 13 in this way, the printed circuit board 3 can easily be removed from inside the housing 1. To enable the engaging projection part 26 to move toward the bottom and sufficiently separate away from the engaged projection part 13, the concave part 12 of the printed circuit board 3 must have a space 15 (see Fig. 4A) allowing the engaging projection part 26 to move toward the bottom.

In the above description, the rear side corresponds to one side in the insertion-extraction direction according to claims; the front side corresponds to the other side in the insertion-extraction direction according to claims; the bottom side corresponds to a direction inclined relative to the insertion-extraction direction and a direction perpendicular to the insertion-extraction direction according to claims; and the top side corresponds to a direction inclined relative to the insertion-extraction direction according to claims.

As described above, in the motor control device 100 of this embodiment, the printed circuit board 3 includes the engaged part 11 on the side surface on the rear side and, when the printed circuit board 3 is inserted in the housing 1, the engaging member 21 disposed on the back wall part 1d on the rear side of the housing 1 engages with the engaged part 11 of the printed circuit board 3. As a result, the movement of the printed circuit board 3 is regulated in the insertion-extraction direction. Specifically, the engagements between the engaging member 21 and the engaged part 11 in the engagement mechanism 6 regulates the movement of the printed circuit board 3 in the direction (to the front) opposite to the insertion direction, and the abutment of the printed circuit board 3 onto the back wall part 1d regulates the movement of the printed circuit board 3 in the insertion direction (to the rear). As a result, the printed circuit board 3 can firmly be fixed to the housing 1.

On the other hand, the engaging member 21 is configured such that the engagement is released by a pressing operation from the outside of the housing 1 toward the front side. Therefore, when the printed circuit board 3 is removed from the housing 1, it is only necessary to perform the operation of pushing the engaging member 21 in the direction (to the front) opposite to the insertion direction of the printed circuit board 3 without using a special jig, and the printed circuit board 3 can extremely easily be removed. This operation may be performed by using a separate jig. Since the engaging member 21 is located on the back wall part 1d on the side opposite to the opening part 1a of the housing 1, an operator may perform the pressing operation of the engaging member 21 while holding the housing 1 with one hand and extract the printed circuit board 3 with the other hand with favorable workability. In this way, the printed circuit board 3 can conveniently be removed from the housing 1.

Particularly in this embodiment, the engaged part 11 of the printed circuit board 3 has the engaged projection part 13 protruding toward the bottom and the concave part 12, and the engaging member 21 of the housing 1 has the engaging projection part 26 protruding toward the top. Because of the engagement between the engaged projection part 13 and the engaging projection part 26 protruding to face with each other in the direction perpendicular to the insertion-extraction direction of the printed circuit board 3 in this way, the movement of the printed circuit board 3 can more reliably be regulated in the insertion-extraction direction to fix the printed circuit board 3 more firmly to the housing 1. Since the engaging projection part 26 is configured to move in the top-bottom direction perpendicular to the insertion-extraction direction, the engagement between the engaged projection part 13 and the engaging projection part 26 and the release thereof can more reliably be switched.

Particularly in this embodiment, a space necessary for the movement of the engaging projection part 26 of the engaging member 21 is ensured in the concave part 12 of the printed circuit board 3. Therefore, the engagement between the engaged projection part 13 and the engaging projection part 26 and the release thereof can more reliably be switched.

Particularly in this embodiment, when the printed circuit board 3 is inserted in the housing 1, (the rear side) of the engaged projection part 13 disposed in the concave part 12 comes into contact with (the front side of) the engaging projection part 26 of the engaging member 21 and, while the engaging projection part 26 is pressed and moved toward the bottom due to this contact, the engaged projection part 13 is engaged with the engaging projection part 26. In this embodiment, since the respective inclined surfaces 14, 27 are disposed on the rear side of the engaged projection part 13 and the front side of the engaging projection part 26, the engaging projection part 26 can smoothly be moved at the time of contact between the both projection parts 13, 26. Therefore, the engaged projection part 13 and the engaging projection part 26 can smoothly be engaged.

Particularly in this embodiment, the male connector 5 is inserted/extracted in the insertion-extraction direction (front-rear direction) of the printed circuit board 3 to/from the female connector 4 mounted on the printed circuit board 3. When this male connector 5 is extracted, an extraction force acts on the printed circuit board 3 in the direction (forward) opposite to the insertion direction (backward) of the printed circuit board 3 and, therefore, if the printed circuit board 3 is weakly fixed to the housing 1, the printed circuit board 3 may come off from the housing 1. In this embodiment, since the printed circuit board 3 can firmly be fixed to the housing 1, the printed circuit board 3 can be prevented from coming off as described above. Therefore, this embodiment is particularly effective for the case of the printed circuit board 3 having the female connector 4 as described above mounted thereon.

Particularly in this embodiment, the concave part 12 having the engaged projection part 13 is disposed on the side surface of the printed circuit board 3 such that the position in the top-bottom direction perpendicular to the insertion-extraction direction of the printed circuit board 3 corresponds to the female connector 4. As a result, the engaged part 11 and the engaging member 21 can be engaged on the side opposite to the position at which the extraction force acts on the printed circuit board 3 and, therefore, the printed circuit board 3 can stably and more firmly be fixed.

Particularly in this embodiment, the engaging member 21 has the first extending part 22 extending along the insertion-extraction direction (front-rear direction) and the second extending part 23 extending along the top-bottom direction perpendicular to the insertion-extraction direction. Since the second extending part 23 has flexibility, the first extending part 22 coupled substantially orthogonally thereto swings and the engaging projection part 26 disposed on the end portion thereof can be configured to move in the top-bottom direction perpendicular to the insertion-extraction direction of the printed circuit board 3. Therefore, a structure can be achieved in which the engaged projection part 13 disposed on the printed circuit board 3 and the engaging projection part 26 of the engaging member 21 are engaged and released.

Particularly in this embodiment, since the engaging member 21 has the third extending part 24, the second extending part 23 is located on the inner side than the back wall part 1d and the first extending part 22 has the protruding part 25 protruding from the position of coupling to the second extending part 23 toward one side in the insertion-extraction direction. This protruding part 25 facilitates the operation of the operator pushing the engaging member 21 from the outside of the housing 1 toward the front side and can improve the operability. Since the protruding part 25 has the tip end substantially flush with the outer peripheral surface of the back wall part 1 d, the protruding part 25 does not protrude from the housing 1. As a result, the installation space can be made smaller and the protruding part 25 does not interfere when the housing 1 is attached, placed, or arranged. The housing 1 can be placed flat with the back wall part 1d facing downward.

The tip end of the protruding part 25 may not necessarily be flush with the outer peripheral surface of the back wall part 1d and may be protruded from the outer peripheral surface of the back wall part 1d. In this case, the operation of the operator pushing the protruding part 25 toward the front side is further facilitated and the operability is further improved.

Although not particularly shown, the arrangement relation of the entire engagement mechanism 6 may be configured completely upside down. In this case, when the engagement is released, the operation may be performed such that the protruding part 25 is pressed and lowered.

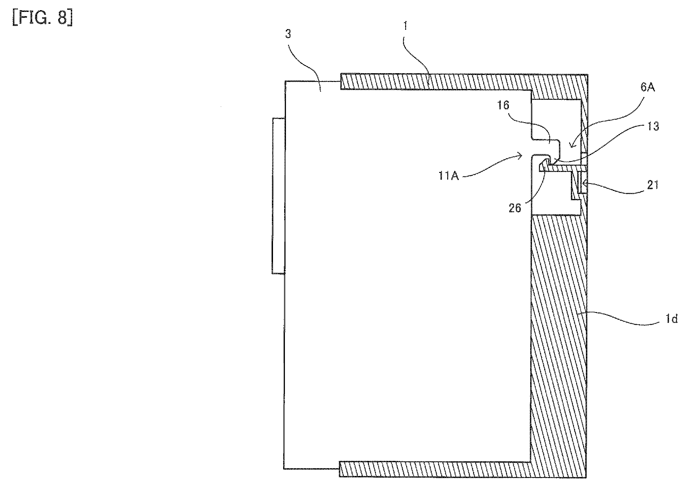

The engaged part 11 of the printed circuit board 3 may be configured to have a convex part 16 as shown in Fig. 8 instead of the concave part 12 with the engaged projection part 13 disposed on the rear side end portion thereof. In this case, to regulate the movement of the printed circuit board 3 in the front-rear direction at the time of engagement of the engagement mechanism 6, the thickness dimension of the back wall part 1d of the housing 1 must be made larger. In particular, the thickness dimension of the back wall part 1d of the housing 1 is set such that the rear edge portion of the printed circuit board 3 other than the periphery of the engagement mechanism 6 can abut at the time of engagement of the engagement mechanism 6.

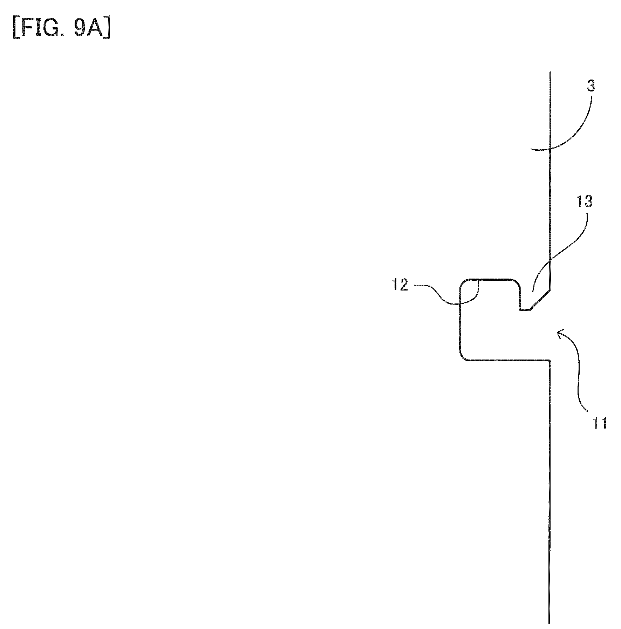

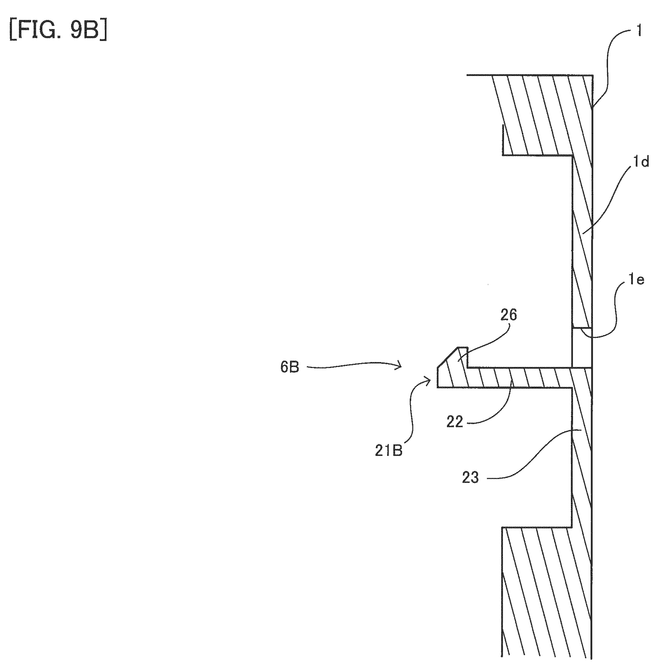

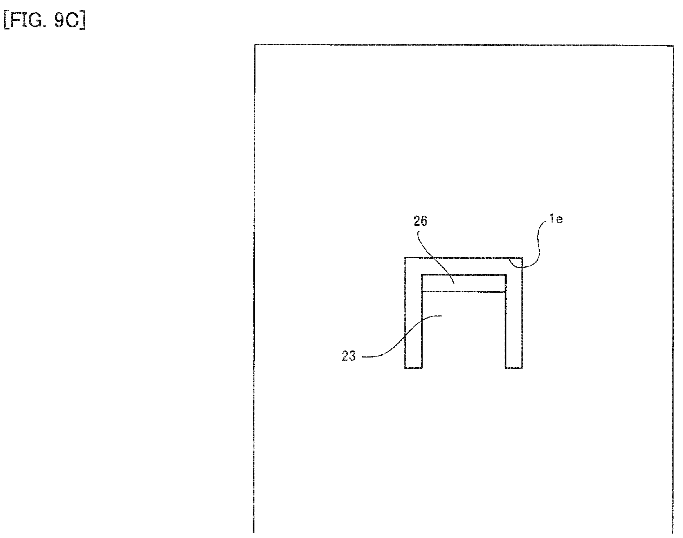

The engaging member 21 may have a simple structure as shown in Figs. 9A to 9C. In particular, the rear side surface of the second extending part 23 may be disposed substantially flush with the outer peripheral surface of the back wall part 1d without disposing the third extending part 24 and the protruding part 25. Fig. 9C is a back view corresponding to Fig. 3D. Even such a configuration enables the engagement of the engagement mechanism 6 by the insertion of the printed circuit board 3 and the release of engagement of the engagement mechanism 6 by the pushing operation of the second extending part 23.

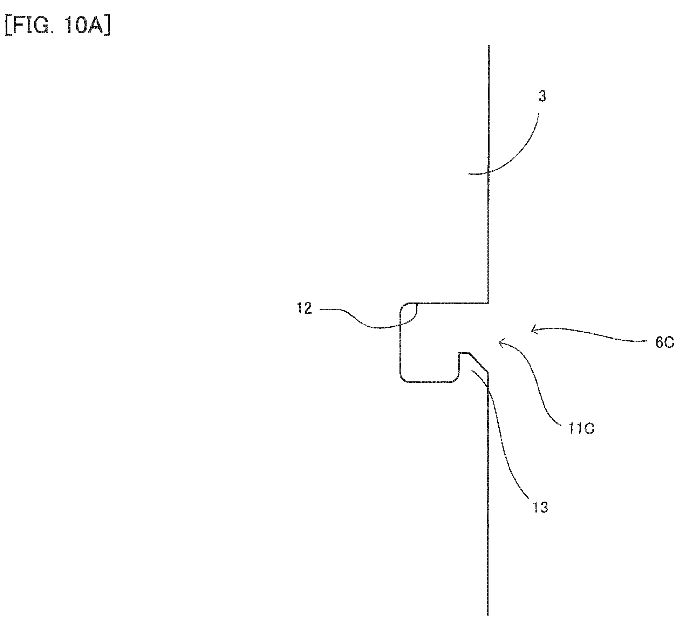

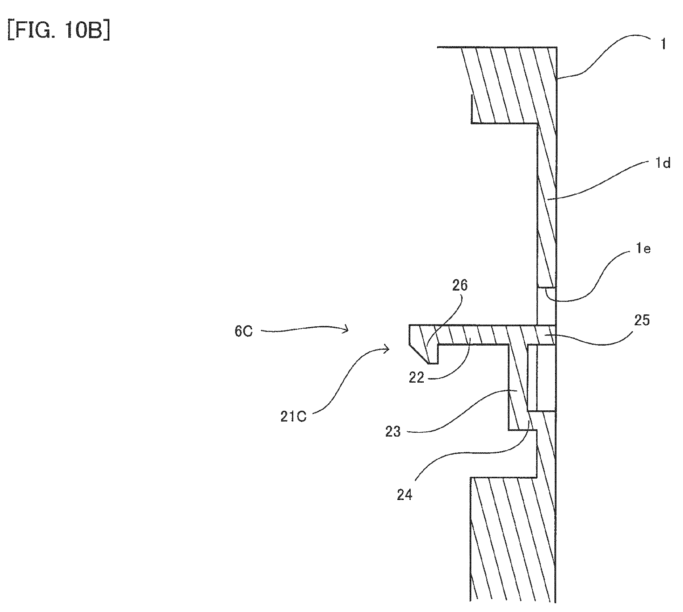

The engaging member 21 may be configured such that the engagement of the engagement mechanism 6 can be canceled by a pulling operation of the protruding part 25. For this configuration, as shown in Fig. 10, the protruding direction (the downward direction shown) of the engaged projection part 13 from the first extending part 22 may be set to the same direction as the coupling direction (the downward direction shown) of the second extending part 23 in the first extending part 22. Additionally, the protruding direction (the upward direction shown) of the engaged projection part 13 in the engaged part 11 is accordingly set. With such a configuration, by operating the protruding part 25 in a pulling manner, the second extending part 23 can be bent to move the engaged projection part 13 in the direction (upward) opposite to the protruding direction thereof (downward) so as to release the engagement between the projection parts 13, 26.

Although the movement of the printed circuit board 3 to the rear (to the one side in the insertion-extraction direction) is regulated by the abutment of the printed circuit board 3 onto the back wall part 1d and the movement of the printed circuit board 3 to the front (to the other side in the insertion-extraction direction) is regulated by the engagement of the engagement mechanism 6, this is not a limitation. In particular, the movement of the printed circuit board 3 in the front-rear direction (insertion-extraction direction) may be regulated by the engagement of the engagement mechanism 6. Although not shown, in this case, for example, the engagement mechanism 6 may have a structure in which the front side end portion of the first extending part 22 abuts on the front side end surface of the concave part 12 when the engaging projection part 26 engages with the engaged projection part 13. Since the first extending part 22 abuts on the concave part 12, the movement of the printed circuit board 3 to the rear (to the one side in the insertion-extraction direction) can also be regulated.

In addition, techniques by the embodiment and each modified example may be appropriately combined and utilized in addition to the examples having already described above. In addition to that, although exemplification is not performed one by one, the embodiment and each modified example are carried out by various changes being applied thereto without departing from the spirit of the present disclosure.

### DESCRIPTION OF SYMBOLS

1 housing
2 lid part
3 printed circuit board
4 female connector (connector)
5 male connector
6, 6A, 6B, 6C engagement mechanism
11, 11A, 11C engaged part
12 concave part
13 engaged projection part (first projection part)
14 inclined surface
15 space
16 convex part
21, 21B, 21C engaging member
22 first extending part
23 second extending part
24 third extending part
25 protruding part
26 engaging projection part (second projection part)
27 inclined surface
100 motor control device

## Claims

1. A motor control device configured to control a motor, the motor control device comprising:
a box-shaped housing including an opening part;
a printed circuit board inserted into the housing and extracted from the housing through the opening part and including an engaged part on a side surface on one side in an insertion-extraction direction; and
an engaging member disposed on a wall part of the housing on the one side in the insertion-extraction direction, engaging with the engaged part of the printed circuit board inserted into the housing to regulate movement of the printed circuit board in the insertion-extraction direction, and being operated toward the one side or another side in the insertion-extraction direction from an outside of the housing to release the engagement.

2. The motor control device according to claim 1, wherein:
the printed circuit board includes, as the engaged part, a concave part including a first projection part protruding in a direction inclined relative to the insertion-extraction direction, and
the engaging member includes, at a tip end, a second projection part protruding in a direction inclined relative to the insertion-extraction direction and is configured in a manner such that the engagement with the first projection part and a release of the engagement are switched by movement of the second projection part in a direction perpendicular to the insertion-extraction direction.

3. The motor control device according to claim 2, wherein:
the concave part includes a space allowing the second projection part to move in the direction perpendicular to the insertion-extraction direction.

4. The motor control device according to claim 1, wherein:
the printed circuit board includes, as the engaged part, a convex part including a first projection part protruding in a direction inclined relative to the insertion-extraction direction, and
the engaging member includes, at a tip end, a second projection part protruding in a direction inclined relative to the insertion-extraction direction and is configured in a manner such that the engagement with the first projection part and a release of the engagement are switched by movement of the second projection part in a direction perpendicular to the insertion-extraction direction.

5. The motor control device according to any one of claims 2 to 4, wherein:
the first projection part includes an inclined surface on the one side in the insertion-extraction direction, and
the second projection part includes an inclined surface on the other side in the insertion-extraction direction.

6. The motor control device according to claim 5, wherein:
the printed circuit board includes a connector, mounted on the printed circuit board, into which a connection target object is inserted and from which the connection target object is extracted in the insertion-extraction direction.

7. A motor control device configured to control a motor, the motor control device comprising:
a box-shaped housing including an opening part;
a printed circuit board inserted into the housing and extracted from the housing through the opening part, including a connector, mounted on the printed circuit board, into which a connection target object is inserted and from which the connection target object is extracted in an insertion-extraction direction, and including an engaged part on a side surface on one side in the insertion-extraction direction at a position corresponding to the connector in a direction perpendicular to the insertion-extraction direction; and
an engaging member disposed on a wall part of the housing on the one side in the insertion-extraction direction, engaging with the engaged part of the printed circuit board inserted into the housing to regulate movement of the printed circuit board in the insertion-extraction direction, and being operated toward the one side or another side in the insertion-extraction direction from an outside of the housing to release the engagement.

8. The motor control device according to claim 7, wherein:
the engaged part is a concave part including a first projection part protruding in a direction inclined relative to the insertion-extraction direction or a convex part including the first projection part protruding in the direction inclined relative to the insertion-extraction direction,
the engaging member includes, at a tip end, a second projection part protruding in a direction inclined relative to the insertion-extraction direction and is configured in a manner such that the engagement with the first projection part and a release of the engagement are switched by movement of the second projection part in the direction perpendicular to the insertion-extraction direction, and
the engaging member includes:
an first extending part extending along the insertion-extraction direction and including the second projection part at an end portion on the other side in the insertion-extraction direction; and
a second extending part with flexibility extending along the direction perpendicular to the insertion-extraction direction and including an end portion on one side coupled to the first extending part and an end portion on another side coupled to the wall part.

9. The motor control device according to claim 8, wherein:
the engaging member is configured in a manner such that a tip end of the first extending part on the one side in the insertion-extraction direction is approximately flush with an outer peripheral surface of the wall part.

10. A motor control device configured to control a motor, the motor control device comprising:
a box-shaped housing including an opening part;
a printed circuit board inserted into the housing and extracted from the housing through the opening part; and
means, disposed on the housing, for engaging with a side surface of the printed circuit board inserted into the housing on one side in an insertion-extraction direction to regulate movement of the printed circuit board in the insertion-extraction direction, and for releasing the engagement by operated toward the one side or another side in the insertion-extraction direction from an outside of the housing.

11. An electronic equipment comprising:
a box-shaped housing including an opening part;
a printed circuit board inserted into the housing and extracted from the housing through the opening part and including an engaged part on a side surface on one side in an insertion-extraction direction; and
an engaging member disposed on a wall part of the housing on the one side in the insertion-extraction direction, engaging with the engaged part of the printed circuit board inserted into the housing to regulate movement of the printed circuit board in the insertion-extraction direction, and being operated toward the one side or another side in the insertion-extraction direction from an outside of the housing to release the engagement.
